(19) Europäisches Patentamt
European Patent Office
Office européen des brevets

(11) **EP 4 174 713 A1**

(12) **EUROPEAN PATENT APPLICATION**

(43) Date of publication:
**03.05.2023   Bulletin 2023/18**

(21) Application number: **22203552.9**

(22) Date of filing: **25.10.2022**

(51) International Patent Classification (IPC):
**G06F 30/27** (2020.01)     **G06F 30/17** (2020.01)

(52) Cooperative Patent Classification (CPC):
**G06F 30/17; G06F 30/27;** G06F 2101/14

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:   **02.11.2021   KR 20210149022**

(71) Applicant: **Samsung Electronics Co., Ltd.
Gyeonggi-do 16677 (KR)**

(72) Inventors:
• **MYUNG, Sanghoon
  16677 Suwon-si, Gyeonggi-do (KR)**
• **JANG, Wonik
  16677 Suwon-si, Gyeonggi-do (KR)**
• **JEONG, Changwook
  16677 Suwon-si, Gyeonggi-do (KR)**
• **CHOE, Jaemyung
  16677 Suwon-si, Gyeonggi-do (KR)**

(74) Representative: **Kuhnen & Wacker
Patent- und Rechtsanwaltsbüro PartG mbB
Prinz-Ludwig-Straße 40A
85354 Freising (DE)**

(54)  **METHOD AND SYSTEM FOR THREE-DIMENSIONAL MODELING**

(57)     A three-dimensional (3D) modeling method includes obtaining geometric data representing a 3D structure and input parameters including factors determining an attribute of the 3D structure, generating grid data from the geometric data, sequentially generating at least one piece of down-sampled data from the grid data, pre-processing the input parameters to generate a 3D feature map, and generating attribute profile data, representing a profile of the attribute in the 3D structure, from the at least one piece of down-sampled grid data and the 3D feature map based on at least one machine learning model respectively corresponding to at least one stage.

**FIG.  13**

EP 4 174 713 A1

**Description**

CROSS-REFERENCE TO RELATED APPLICATION

This U.S. non-provisional patent application is based on and claims priority under 35 U.S.C. §119 to Korean Patent Application No. 10-2021-0149022, filed on November 02, 2021, in the Korean Intellectual Property Office, the disclosure of which is incorporated by reference herein in its entirety.

BACKGROUND

The inventive concept(s) described herein relate to three-dimensional modeling, and more particularly, to a method and system of modeling a three-dimensional structure.

A simulation based on a three-dimensional structure may incur high cost. For example, in simulating an attribute of a device formed under a condition in a semiconductor process or simulating a state of the device in a predetermined environment, a high computing resource for performing various physical interpretations may be needed, and a long time may be taken in completing a simulation. Also, due to performance or various factors of a simulator, the accuracy of a simulation result may decrease.

SUMMARY

The inventive concept(s) described herein provide a method and system for modeling a three-dimensional structure at low cost and high accuracy.

According to an aspect of the present disclosure, a 3D modeling (three-dimensional modeling) method includes obtaining geometric data representing a 3D structure and input parameters including factors determining an attribute of the 3D structure, generating grid data from the geometric data, sequentially generating at least one piece of down-sampled data from the grid data, generate a 3D feature map by pre-processing the input parameters, and generating attribute profile data, representing a profile of the attribute in the 3D structure, from the at least one piece of down-sampled grid data and the 3D feature map based on at least one machine learning model respectively corresponding to at least one stage.

According to another aspect of the present disclosure, a 3D modeling ( three-dimensional modeling) method including obtaining attribute profile data representing a profile of an attribute of a 3D structure and input parameters representing an environment of the 3D structure, generating grid data from the geometric data, sequentially generating at least one piece of down-sampled data from the grid data, generating a 3D feature map from the grid data, the at least one piece of down-sampled grid data, and the input parameters based on at least one first machine learning model respectively corresponding to at least one first stage, and generating state data representing a state of the 3D structure in the environment by post-processing the 3D feature map.

According to another aspect of the present disclosure, there is provided a system including at least one processor and a non-transitory storage medium configured to store instructions allowing the at least one processor to perform a 3D modeling method when the instructions are executed by the at least one processor.

According to another aspect of the present disclosure, there is provided a non-transitory computer-readable storage medium including instructions allowing the at least one processor to perform a 3D modeling method when the instructions are executed by the at least one processor.

BRIEF DESCRIPTION OF THE DRAWINGS

Embodiments of the present disclosure will be more clearly understood from the following detailed description taken in conjunction with the accompanying drawings in which:

FIG. 1 is a diagram illustrating three-dimensional modeling according to an embodiment;
FIG. 2A and FIG. 2B are diagrams illustrating examples of grid data according to embodiments;
FIG. 3 is a diagram illustrating pre-processing according to an embodiment;
FIG. 4 is a diagram illustrating an up-sampling based model according to an embodiment;
FIG. 5 is a diagram illustrating an up-sampling based model according to an embodiment;
FIG. 6 is a diagram illustrating a residual block according to an embodiment;
FIG. 7 is a diagram illustrating three-dimensional modeling according to an embodiment;
FIG. 8 is a diagram illustrating three-dimensional modeling according to an embodiment;
FIG. 9 is a diagram illustrating a down-sampling based model according to an embodiment;
FIG. 10 is a diagram illustrating a down-sampling based model according to an embodiment;

FIG. 11 is a diagram illustrating post-processing according to an embodiment;
FIG. 12A, FIG. 12B and FIG. 12C are flowcharts illustrating examples of three-dimensional modeling according to embodiments;
FIG. 13 is a flowchart illustrating a method for three-dimensional modeling according to an embodiment;
FIG. 14 is a flowchart illustrating a method for three-dimensional modeling according to an embodiment;
FIG. 15 is a flowchart illustrating a method for three-dimensional modeling according to an embodiment;
FIG. 16 is a block diagram illustrating a computer system according to an embodiment; and
FIG. 17 is a block diagram illustrating a system according to an embodiment.

DETAILED DESCRIPTION OF THE EMBODIMENTS

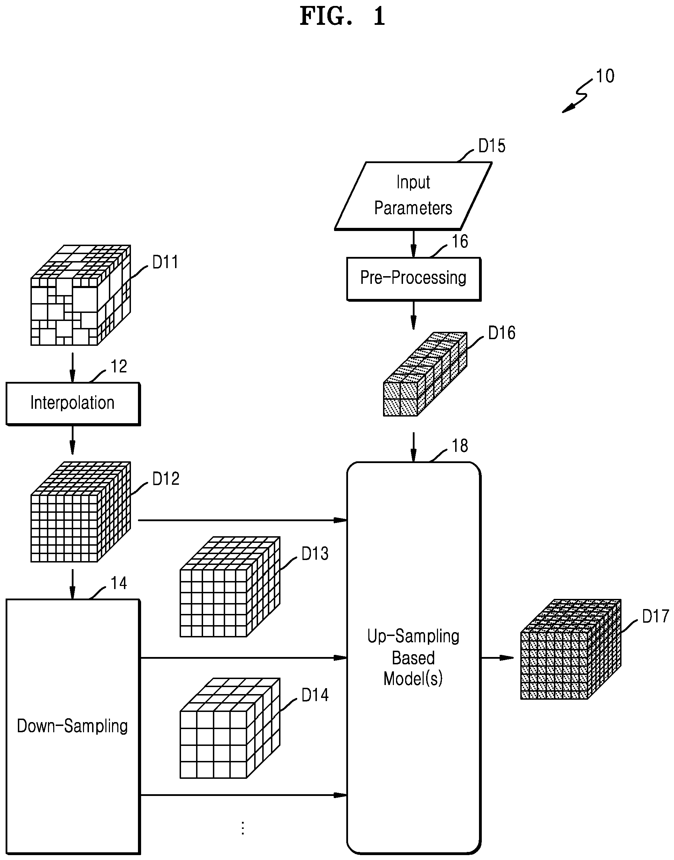

FIG. 1 is a diagram illustrating 3D modeling 10 (three-dimensional modeling) according to an embodiment. The 3D modeling 10 may process geometric data D11 representing a 3D structure and input parameters D15 including factors determining an attribute of a 3D structure. The processing in the 3D modeling 10 may be performed to generate attribute profile data D17 representing a profile of an attribute of a 3D structure such as a device of an integrated circuit. Herein, a doping concentration and a device formed by a semiconductor process will be described as an example of an attribute and a 3D structure, but embodiments are not limited thereto. As illustrated in FIG. 1, the 3D modeling 10 may include and/or involve interpolation 12, down-sampling 14, pre-processing 16, and at least one up-sampling based model 18.

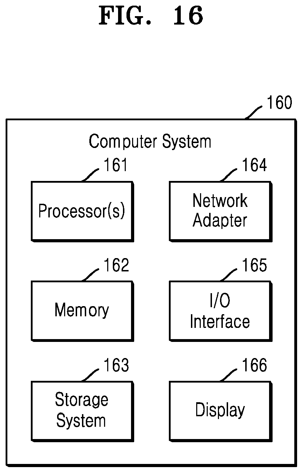

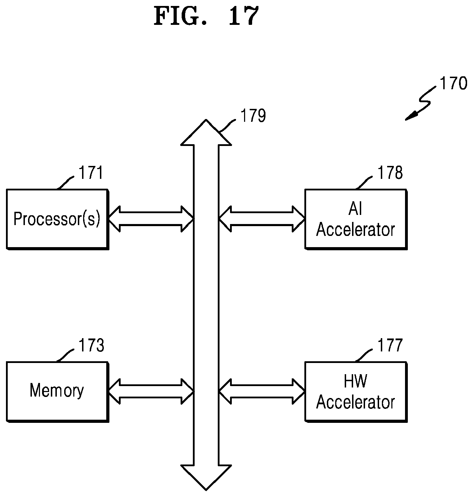

In some embodiments, the 3D modeling 10 of FIG. 1 may be performed by a computer system as described below with reference to FIG. 16 and FIG. 17. For example, each of the blocks illustrated in FIG. 1 may correspond to hardware, software, or a combination of hardware and software, which is included in a computer system. Hardware may include at least one of a programmable component such as a central processing unit (CPU), a digital signal processor (DSP), or a graphics processing unit (GPU), a reconfigurable component such as a field programmable gate array (FPGA), and a component which provides a fixed function such as an IP block (intellectual property block). An IP block may comprise a unique circuit that may be individually protected or protectable as intellectual property. Software may include at least one of a series of instructions executable by a programmable component and code convertible into a series of instructions by a compiler, and may be stored in a non-transitory storage medium.

The geometric data D11 may represent a 3D structure for modeling or simulation. For example, the geometric data D11 may be data representing a 3D structure for simulating an attribute of a 3D structure by using a simulator. As illustrated in FIG. 1, the geometric data D11 may represent a 3D structure based on a non-uniform grid.

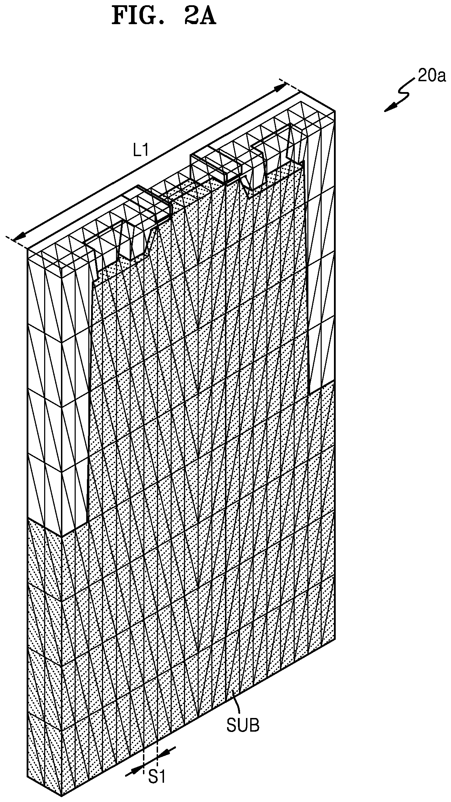

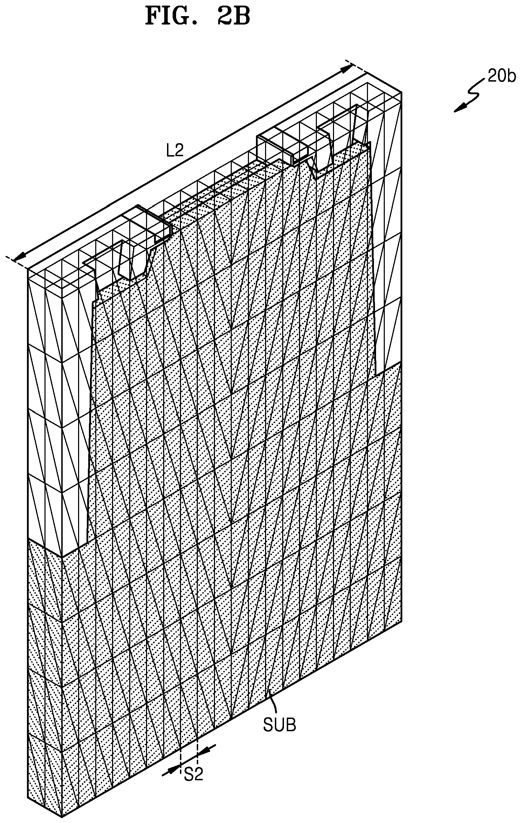

The interpolation 12 may generate grid data D12 from the geometric data D11. In order to be learned or inferred by a machine learning model (e.g., by at least one up-sampling based model 18 described below), the grid data D12 provided to the at least one up-sampling based model 18 may be based on a uniform grid. A uniform grid may have a constant interval between elements (i.e., may have the same interval between adjacent intersections in and throughout one or more dimensions). As described above, the geometric data D11 may be based on a non-uniform grid, and thus, a grid of the geometric data D11 may be interpolated, whereby the grid data D12 having a uniform grid may be generated. In some embodiments, an interval in a grid of the grid data D12 may correspond to a minimum interval in a grid of the geometric data D11. Also, in some embodiments, the grid data D12 may be based on a Cartesian coordinate system and may include values respectively corresponding to X, Y, and Z directions. Examples of the grid data D12 will be described below with reference to FIG. 2A and FIG. 2B.

In the down-sampling 14, the grid data D12 may be down-sampled. As described below, a 3D feature map D16 generated from the input parameters D15 may have a low resolution. Therefore, pieces of down-sampled grid data D13 and D14 generated from the grid data D12 may be provided to the at least one up-sampling based model 18. In some embodiments, the grid data D12 may be provided to a network (for example, a convolution neural network) to generate the pieces of down-sampled grid data D13 and D14. Also, in some embodiments, the down-sampling 14 may be based on max pooling and average pooling.

The input parameters D15 may include factors for determining an attribute of a 3D structure. For example, the input parameters D15 may include process parameters for determining a doping profile of a semiconductor device, and for example, may include a dopant, a dose, an implantation tilt, implantation energy, and a temperature. In some embodiments, the input parameters D15 may be the same as parameters provided to a simulator.

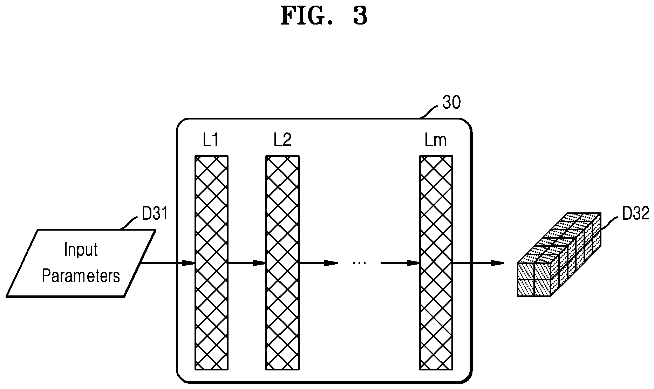

The pre-processing 16 may generate a 3D feature map from the input parameters D15. The input parameters D15 may be a series of values and may correspond to one-dimensional (1D) data. The 3D feature map D16 may be generated from the input parameters D15 and is provided to an up-sampling based model along with the grid data D12 including geometric information about a 3D structure and the down-sampled grid data D13 and D14 generated from the grid data D12. An example of the pre-processing 16 will be described below with reference to FIG. 3.

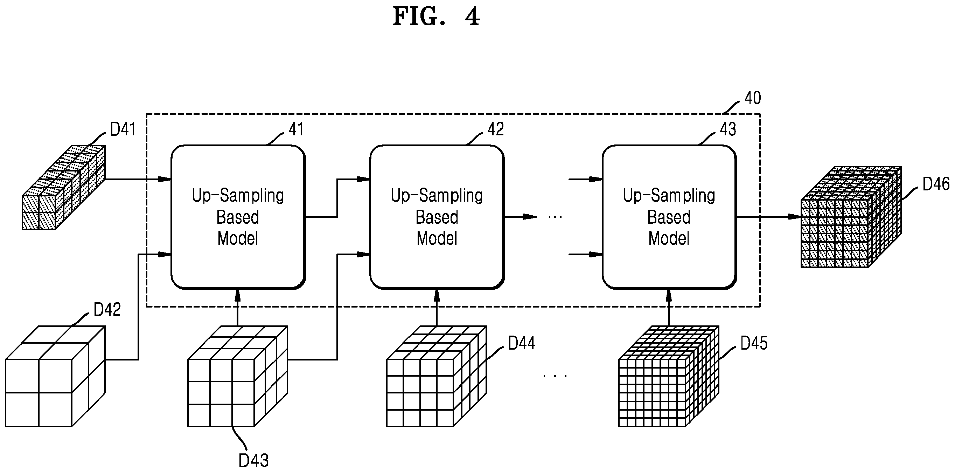

The at least one up-sampling based model 18 may receive the grid data D12, the down-sampled grid data D13 and D14, and the 3D feature map D16 and may output attribute profile data D17. Each of the at least one up-sampling based model 18 may be a machine learning model and may be trained to output grid data and a 3D feature map. As described below with reference to FIG. 4, the at least one up-sampling based model 18 may include a series of stages, and each of the stages may include an up-sampling based model having the same structure. A resolution of a 3D feature map may progressively increase as the number of operations of passing through a stage increases. For example, in the illustration of FIG. 1, a stage (or an up-sampling based model) receiving the 3D feature map D16 may receive grid data having a lowest resolution provided by the down-sampling 14, and a final stage may receive grid data having a highest resolution along with an output (i.e., a 3D feature map) of a previous stage. An example of the at least one up-sampling based model 18 will be described below with reference to FIG. 4.

For example, at least one piece of down-sampled data from the down-sampling 14 may be sequentially generated by generating second grid data (e.g., the down-sampled grid data D13 and D14) via down-sampling first grid data (e.g., the grid data D12). A first machine learning model (e.g., one of the at least one up-sampling based model 18) may be executed based on output data of a previous stage, the first grid data, and the second grid data. The first machine learning model may be executed to generate the attribute profile data D17. As explained below, the executing of the first machine learning model may include concatenating the output data of a previous first stage with the first grid data, executing a convolution layer based on concatenated data, down-sampling output data of the convolution layer, and executing a series of residual blocks based on down-sampled data and the second grid data.

Herein, a machine learning model may have an arbitrary trainable structure. For example, the machine learning model may include an artificial neural network, a decision tree, a support vector machine, a Bayesian network, and/or a genetic algorithm. Hereinafter, the machine learning model will be described with reference to an artificial neural network, but embodiments are not limited thereto. The artificial neural network, as a non-limiting example, may include a convolution neural network (CNN), a region with convolution neural network (R-CNN), a region proposal network (RPN), a recurrent neural network (RNN), a stacking-based deep neural network (S-DNN), a state-space dynamic neural network (S-SDNN), a deconvolution network, a deep belief network (DBN), a restricted Boltzmann machine (RBM), a fully convolutional network, a long short-term memory (LSTM) network, and a classification network. Herein, the machine learning model may be simply referred to as a model.

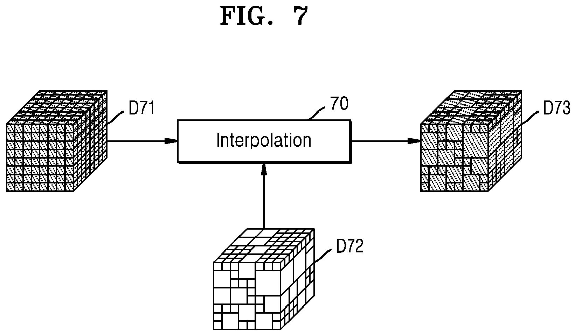

According to an experiment result, the 3D modeling 10 of FIG. 1 may generate a result (i.e., attribute profile data D17) almost similar to a simulator, but a time taken by the 3D modeling 10 may correspond to about 1/100,000 of a performance time of the simulator. Therefore, a 3D structure may be accurately modeled in a relatively short time by using few resources, and moreover, as described below with reference to FIG. 7, the attribute profile data D17 may be converted into a format compatible with the simulator, whereby a simulation and/or modeling based on the attribute profile data D17 may be completed relatively quickly. As a result, a verification of a 3D structure may be easily completed, and a time-to-market (TTM) of a product including the 3D structure may be considerably shortened.

FIG. 2A and FIG. 2B are diagrams illustrating examples of grid data according to embodiments. In detail, FIG. 2A and FIG. 2B illustrate transistors formed by a semiconductor process and a grid for defining a structure of a transistor as an example of a 3D structure. As described above with reference to FIG. 1, grid data 20a of FIG. 2A and grid data 20b of FIG. 2B may be generated by interpolating geometric data D11 representing a 3D structure. Hereinafter, FIG. 2A and FIG. 2B will be described with reference to FIG. 1.

Each of the grid data 20a of FIG. 2A and the grid data 20b of FIG. 2B may include values corresponding to a grid having a uniform interval. For example, a grid in the grid data 20a of FIG. 2A may have a first interval S1, and a grid in the grid data 20b of FIG. 2B may have a second interval S2. The grid data 20a of FIG. 2A may represent a transistor having a first length L1, and the grid data 20b of FIG. 2A may represent a transistor having a second length L2, which is longer than the first length L1 (L2>L1).

The 3D feature map D16 generated by the pre-processing 16 described above with reference to FIG. 1 may have a certain size. Therefore, the interpolation 12 may generate the grid data D12 having a certain number of grids independently from a certain size of a 3D structure represented by the geometric data D11, so that the grid data D12 provided to the at least one up-sampling based model 18 has a certain size. Therefore, the second interval S2 of FIG. 2B may be greater than the first interval S1 of FIG. 2A (S2>S1).

In some embodiments, an attribute of a portion of a 3D structure (e.g., less than all of the 3D structure) may be considered. For example, as illustrated in FIG. 2A and FIG. 2B, a doping concentration in a substrate SUB of a transistor may be considered. Herein, as the substrate SUB of FIG. 2A and FIG. 2B, a portion, requiring an attribute, of a 3D structure may be referred to as a region of interest (ROI). In some embodiments, the interpolation 12 may mask values, corresponding to a region, other than an ROI, of the 3D structure, as a certain value. For example, values corresponding to a region, other than an ROI, of a 3D structure in the grid data D12 may be set to zero in the interpolation 12. A 3D modeling method may include a step of generating grid data from geometric data by setting values, corresponding to a region except for the ROI of the 3D structure, to zero.

FIG. 3 is a diagram illustrating pre-processing 30 according to an embodiment. As described above with reference to FIG. 1, input parameters D31 including factors for determining an attribute of a 3D structure may be pre-processed, and a 3D feature map D32 may be generated.

In some embodiments, the pre-processing 30 may include and/or involve a network and may include at least one layer. For example, as illustrated in FIG. 3, the pre-processing 30 may include and/or involve first to $m^{th}$ layers L1 to Lm (where m is an integer more than 1), and the first to $m^{th}$ layers L1 to Lm may process the input parameters D31 or an output of a previous layer. In some embodiments, each of the first to $m^{th}$ layers L1 to Lm may be a fully connected layer or a dense layer. The pre-processing 30 may be trained along with the at least one up-sampling based model 18 of FIG. 1. As described above with reference to FIG. 1, the 3D feature map D32 generated by pre-processing the input parameters D31 may have a low resolution.

FIG. 4 is a diagram illustrating an up-sampling based model according to an embodiment. In detail, FIG. 4 illustrates an example of the at least one up-sampling based model 18 of FIG. 1. As described above with reference to FIG. 1, a 3D feature map D41, grid data D42, and pieces of down-sampled grid data D43 to D45 may be provided to at least one up-sampling based model 40, and attribute profile data D46 may be generated from the at least one up-sampling based model 40.

Referring to FIG. 4, the at least one up-sampling based model 40 may include a series of up-sampling based models including a first up-sampling based model 41, a second up-sampling based model 42, and a third up-sampling based model 43, and each of the first up-sampling based model 41, the second up-sampling based model 42 and the third up-sampling based model 43 may have the same structure. For example, the first up-sampling based model 41 of a first stage may receive the 3D feature map D41 and the grid data D43 and may receive the grid data D42 down-sampled from the grid data D43. The second up-sampling based model 42 of a second stage may receive the grid data D44 and a 3D feature map output from the first up-sampling based model 41 of the first stage and may receive the grid data D43 down-sampled from the grid data D44. The third up-sampling based model 43 of a final stage may receive the grid data D45 and a 3D feature map output from an up-sampling based model of a previous stage and may receive grid data down-sampled from the grid data D45. The grid data D45 received by the third up-sampling based model 43 of the final stage may have a highest resolution and may correspond to the grid data D12 generated from the geometric data D11 by the interpolation 12 of FIG. 1.

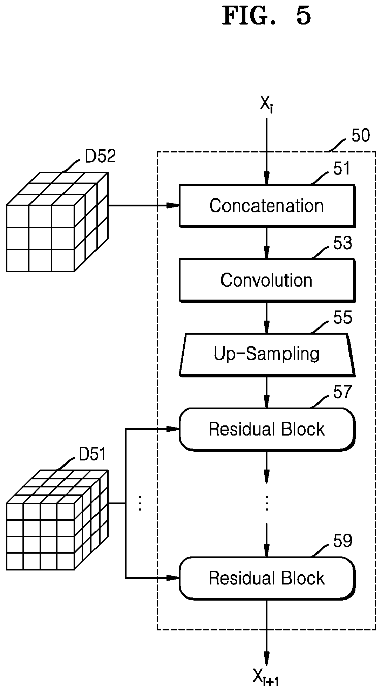

An up-sampling based model (for example, 41) in each stage may output a 3D feature map having a higher resolution than that of an input 3D feature map (for example, D41) based on grid data D42 having a relatively lower resolution and grid data D43 having a relatively higher resolution. Therefore, attribute profile data D46 representing an attribute profile of a 3D structure may be generated from a 3D feature map D41 generated by pre-processing the input parameters D15 of FIG. 1 by using a series of up-sampling based models. As described below with reference to FIG. 5, an up-sampling based model may include at least one residual block RB. Therefore, the at least one residual block RB included in the up-sampling based model may be referred to as an up-sampling based residual block RB.

FIG. 5 is a diagram illustrating an up-sampling based model 50 according to an embodiment. In detail, FIG. 5 illustrates an up-sampling based model 50 included in an $i^{th}$ stage of stages included in the at least one up-sampling based model 40 of FIG. 4 (where i is an integer more than 0). As described above with reference to FIG. 4, the up-sampling based model 50 may receive a 3D feature map $X_i$ having a lower resolution, grid data D52 having a lower resolution, and grid data D51 having a higher resolution and may output a 3D feature map $X_{i+1}$ having a higher resolution.

Hereinafter, the 3D feature map $X_i$ having a lower resolution may be referred to as an input feature map $X_i$, and the 3D feature map $X_{i+1}$ having a higher resolution may be referred to as an output feature map $X_{i+1}$. Also, the grid data D51 having a higher resolution may be referred to as first grid data D51, and the grid data D52 having a lower resolution may be referred to as second grid data D52. The input feature map $X_i$ may be a 3D feature map (for example, D41 of FIG. 4), generated by pre-processing the input parameters D15, or a feature map output from a previous stage. Also, the output feature map $X_{i+1}$ may be attribute profile data (for example, D46 of FIG. 4) or a feature map provided to a next stage.

Referring to FIG. 5, the up-sampling based model 50 may include a concatenation 51, a convolution 53, up-sampling 55, and a series of residual blocks 57 and 59. In the concatenation 51, values of the input feature map $X_i$ may be concatenated with values of the second grid data D52. As described above with reference to FIG. 1, and FIG. 4, the second grid data D52 may be down-sampled from the first grid data D51 to have the same resolution as that of the input feature map $X_i$, and thus, the input feature map $X_i$ may be concatenated with the second grid data D52.

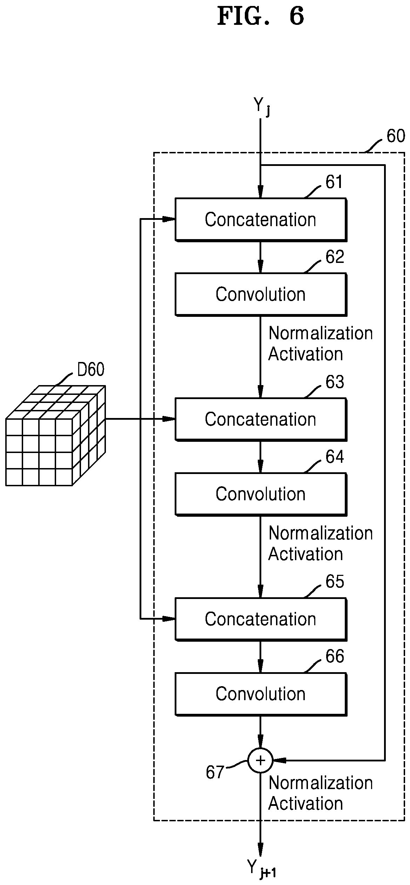

A result of the concatenation 51 may be provided to the convolution 53 (or a convolution layer), and a result of the convolution 53 may be provided to the up-sampling 55 (or an up-sampling layer). The up-sampling 55 may be performed based on an arbitrary scheme, and for example, a value may be copied to added grids. Therefore, a result of the up-sampling 55 may have a resolution which is higher than that of each of the input feature map $X_i$ and the second grid data D52. The result of the up-sampling 55 may be provided to the series of residual blocks 57 and 59. High complexity caused by a deep network in deep learning may require a number of resources, and a depth of a network may not be proportional to performance of the network. In order to solve such a problem, residual learning may be used. The residual learning may denote that low-resolution data is added to high-resolution data and a difference value between two pieces of data is learned. For example, in ResNet proposed in the paper "Deep Residual Learning for Image Recognition", a network may be divided into a plurality of residual blocks so as to more stably train a deep network and the plurality of residual blocks may be connected to one another through a skip connection, and thus, filter parameters may be more easily optimized. As illustrated in FIG. 5, each of the residual blocks 57 and 59 may receive the first grid data D51 as well as an output of a previous residual block. An example of each of the residual blocks 57 and 59 will be described below with reference to FIG. 6.

As an example implementation of embodiments based on FIG. 4 and FIG. 5 described above, the first up-sampling based model 41 may be of a first stage, the second up-sampling based model 42 may be of a second stage, and the third up-sampling based model 43 may be of a third and final stage. Executing a first machine learning model (e.g., the second up-sampling based model 42 of the second stage) may include concatenating the output data of the first stage and the second grid data D52. Executing the first machine learning mode in these embodiments may also include executing a convolution layer (or the convolution 53) based on concatenated data, up-sampling output data of the convolution layer (or the convolution 53) by the up-sampling 55, and executing a series of residual blocks 57 and 59 based on up-sampled data and first grid data.

FIG. 6 is a diagram illustrating a residual block 60 according to an embodiment. As described above with reference to FIG. 5, an up-sampling based model may include a series of residual blocks, and in some embodiments, each of the residual blocks may have the same structure as that of the residual block 60 of FIG. 6. Hereinafter, FIG. 6 will be described with reference to FIG. 5.

Referring to FIG. 6, the residual block 60 may receive an input $Y_j$ and grid data D60 and may generate an output $Y_{j+1}$. The input $Y_j$ may be an output of a previous residual block or an output of the up-sampling 55 of FIG. 5. The output $Y_{j+1}$ may be provided to a next residual block, or may be an output $X_{i+1}$ of the up-sampling based model 50 including the residual block 60. As illustrated in FIG. 6, the residual block 60 may include a first concatenation 61, a second concatenation 63, and a third concatenation 65, a first convolution 62, a second convolution 64, and a third convolution 66, and an adder 67.

In the first concatenation 61, values of the input $Y_j$ may be concatenated with values of the grid data D60, and a result of the first concatenation 61 may be provided to the first convolution 62. In some embodiments, a filter in the first convolution 62 may have a $1\times1$ size, and the first convolution 62 may include filters corresponding to 1/4 of the number of filters included in the third convolution 66. In some embodiments, as illustrated in FIG. 6, a result of the first convolution 62 may be normalized and activated, and a normalized and activated result may be provided to the second concatenation 63.

In the second concatenation 63, a result of the first convolution 62 may be concatenated with the values of the grid data D60, and a result of the second concatenation 63 may be provided to the second convolution 64. In some embodiments, a filter in the second convolution 64 may have a 3x3 size, and the second convolution 64 may include filters corresponding to 1/4 of the number of filters included in the third convolution 66. In some embodiments, as illustrated in FIG. 6, a result of the second convolution 64 may be normalized and activated, and a normalized and activated result may be provided to the third concatenation 65.

In the third concatenation 65, a result of the second convolution 64 may be concatenated with the values of the grid data D60, and a result of the third concatenation 65 may be provided to the third convolution 66. In some embodiments, the third convolution 66 may include a plurality of filters, and each of the plurality of filters may have a $1\times1$ size. In some embodiments, as illustrated in FIG. 6, a result of the third convolution 66 may be normalized and activated, and a normalized and activated result may be provided to the adder 67.

The adder 67 may add the input $Y_j$ to an output of the third convolution 66. In some embodiments, as illustrated in FIG. 6, a result of the adder 67 may be normalized and activated, and a normalized and activated result may be generated as the output $Y_{j+1}$.

FIG. 7 is a diagram illustrating three-dimensional modeling according to an embodiment. In detail, FIG. 7 illustrates an operation of generating attribute profile data D73 compatible with a simulator by processing attribute profile data D71 generated by the 3D modeling of FIG. 1. Hereinafter, the attribute profile data D71 generated by 3D modeling may be referred to as first profile data D71, and the attribute profile data D73 compatible with the simulator may be referred to as second profile data D73.

As described above with reference to FIG. 1, grid data D12 having a uniform grid may be generated from geometric data D72 representing a 3D structure. Profile data representing an attribute of a 3D structure may be used to simulate or model a state of a 3D structure based on conditions. To this end, profile data may need to have a format needed for a simulator, and for example, may be required to have the same grid as that of the geometric data D72. Therefore, based on the geometric data D72, the first profile data D71 having a uniform grid in interpolation 70 may be converted into the second profile data D73 having the same grid as that of the geometric data D72. In some embodiments, when the grid of the first profile data D71 corresponds to a minimum grid of the geometric data D72, down-sampling may be performed in the interpolation 70. As a result, the 3D modeling of FIG. 1 may replace a simulator, which simulates an attribute of a 3D structure, and thus, the cost for verifying a state as well as the attribute of the 3D structure may be considerably reduced.

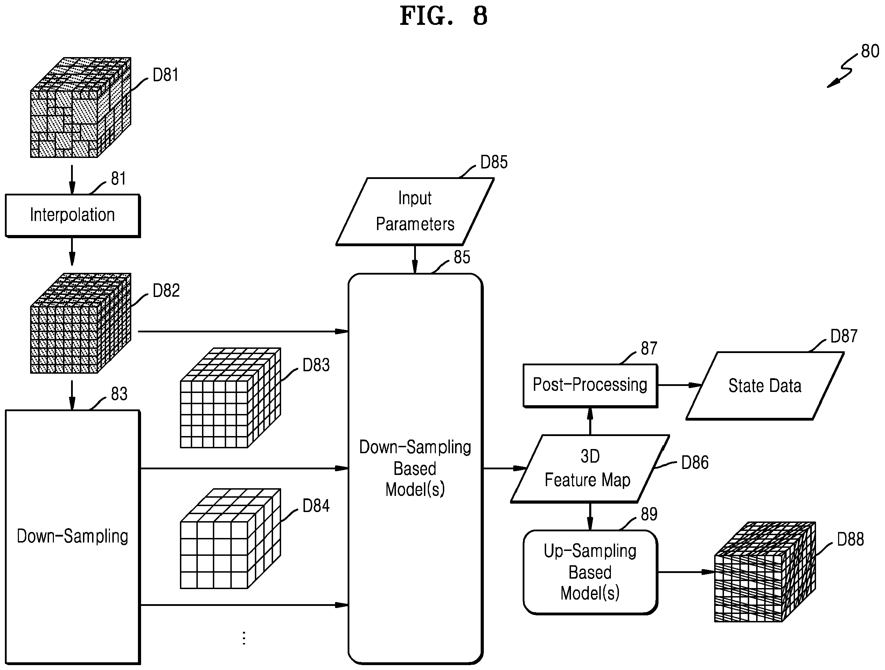

FIG. 8 is a diagram illustrating 3D modeling 80 according to an embodiment. The 3D modeling 80 may process attribute profile data D81 representing an attribute of a 3D structure and input parameters D85 including factors determining a state of the 3D structure to generate state data D87 and state profile data D88 representing the state of the attribute of a 3D structure. As illustrated in FIG. 8, the 3D modeling 80 may include interpolation 81, down-sampling 83, at least one down-sampling based model 85, post-processing 87, and at least one up-sampling based model 89. Hereinafter, in describing FIG. 8, the same description as the description of FIG. 1 is omitted.

In some embodiments, the 3D modeling 80 of FIG. 8 may be performed by a computer system as described below with reference to FIG. 16 and FIG. 17. For example, each of the blocks illustrated in FIG. 8 may correspond to hardware, software, or a combination of hardware and software, which is included in a computer system. Hardware may include at least one of a programmable component such as a CPU, a DSP, or a GPU, a reconfigurable component such as an FPGA, and a component which provides a fixed function such as an IP block. Software may include at least one of a series of instructions executable by a programmable component and code convertible into a series of instructions by a compiler, and may be stored in a non-transitory storage medium.

The attribute profile data D81 may three-dimensionally represent an attribute of a 3D structure. For example, the attribute profile data D81 may be generated by the 3D modeling 10 and the interpolation 70 of FIG. 1 as described above with reference to FIG. 7, or may be generated by a simulator, which simulates an attribute of a 3D structure. As illustrated in FIG. 8, the attribute profile data D81 may three-dimensionally represent an attribute based on a non-uniform grid.

The interpolation 81 may generate grid data D82 from the attribute profile data D81. The grid data D82 provided to the at least one down-sampling based model 85 may be based on a uniform grid, so as to be learned or inferred by the at least one down-sampling based model 85 described below. As described above, the attribute profile data D81 may be based on a non-uniform grid. Therefore, a grid of the attribute profile data D81 may be interpolated, whereby the grid data D82 having a uniform grid may be generated. Unlike the grid data D12 of FIG. 1 which has only values corresponding to coordinates, the grid data D82 of FIG. 8 may include a value representing an attribute in corresponding coordinates, in addition to values corresponding to coordinates.

In the down-sampling 83, the grid data D82 may be down-sampled. As described below, a 3D feature map D86 generated in the at least one down-sampling based model 85 may have a low resolution. Therefore, pieces of grid data D83 and D84 down-sampled from the grid data D82 may be provided to the at least one down-sampling based model 85. In some embodiments, the grid data D82 may pass through a network (for example, a CNN) to generate the down-sampled grid data D83 and D84. Also, in some embodiments, the down-sampling 83 may be performed based on max pooling, average pooling, or the like.

The input parameters D85 may include factors for determining a state of a 3D structure. For example, the input parameters D85 may include parameters representing an environment of a 3D structure such as a voltage and a temperature each provided to a semiconductor device. In some embodiments, the input parameters D85 may be the same as parameters provided to a simulator. When the attribute profile data D81 represents a doping profile of a transistor and the input parameters D85 represent voltages applied to the transistor, state data D87 may represent a current characteristic (for example, a voltage-current graph), and state profile data D88 may represent a density of an electron and/or a hole in the transistor.

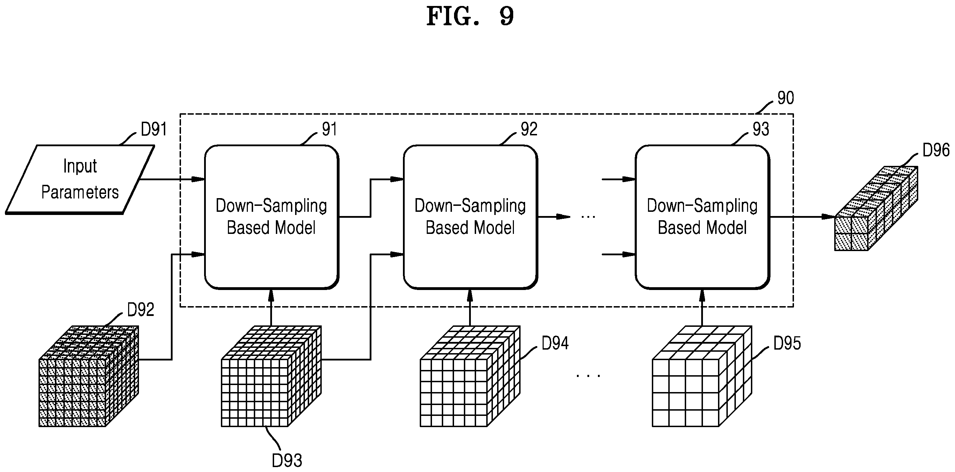

The at least one down-sampling based model 85 may receive the grid data D82, the down-sampled grid data D83 and D84, and the input parameters D85 and may output the 3D feature map D16. Each of the at least one down-sampling based model 85 may be a machine learning model and may be trained to output grid data and a 3D feature map. As described above with reference to FIG. 9, the at least one down-sampling based model 85 may include a series of stages, and each of the stages may include a down-sampling based model having the same structure. A resolution of a 3D feature map may progressively decrease as the number of operations of passing through a stage increases. An example of the at least one down-sampling based model 85 will be described below with reference to FIG. 9.

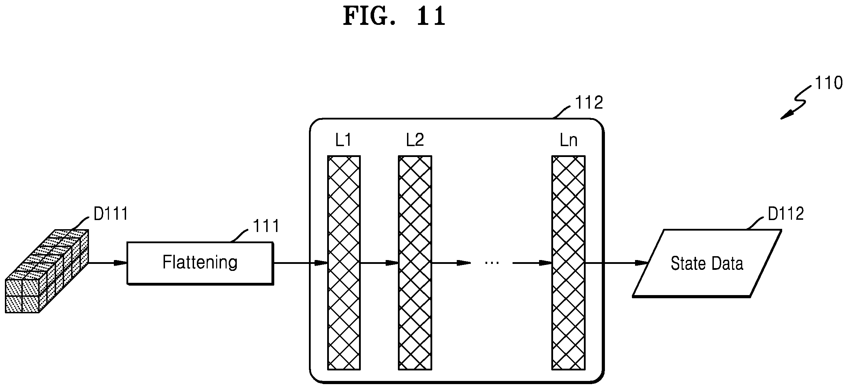

Based on the post-processing 87, the state data D87 may be generated from the 3D feature map D86. The state data D86 may represent a state of a 3D structure having an attribute of the attribute profile data D81 under a condition corresponding to the input parameters D85. An example of the post-processing 87 will be described below with reference to FIG. 11.

The at least one up-sampling based model 89 may output the state profile data D88 from the 3D feature map D86. For example, the at least one up-sampling based model 89 may have the same structure as that of the at least one up-sampling based model 40 of FIG. 4, and moreover, may receive the grid data D82 and the down-sampled grid data D83 and D84 as well as the 3D feature map D86. The 3D feature map D86 may include information representing a state of a 3D structure under a predetermined condition. The at least one up-sampling based model 89 may progressively increase a resolution of the 3D feature map D86 to generate the state profile data D88, based on grid data.

Compared to a simulator, the 3D modeling 10 of FIG. 1 and the 3D modeling 10 of FIG. 8 may provide various advantages. For example, the 3D modeling 10 and 80 may incur cost (for example, resources and time), which is lower than that of the simulator. The 3D modeling 10 and 80 may easily verify a 3D structure under a corner condition based on the low cost, and thus, a defect caused by the 3D structure may be easily detected. Also, the simulator may fail in calculating a result, but the 3D modeling 10 and 80 may always output a result. Also, the 3D modeling 10 and 80 may use an input and an output compatible with the simulator and may provide an accurate result.

FIG. 9 is a diagram illustrating a down-sampling based model according to an embodiment. In detail, FIG. 9 illustrates an example of the at least one down-sampling based model 85 of FIG. 8. As described above with reference to FIG. 8, input parameters D91, grid data D92, and pieces of down-sampled grid data D93 to D95 may be provided to at least one down-sampling based model 90 of FIG. 9, and a 3D feature map D96 may be generated from the at least one down-sampling based model 90.

Referring to FIG. 9, the at least one down-sampling based model 90 may include a series of down-sampling based models including a first down-sampling based model 91, a second down-sampling based model 92 and a third down-sampling based model 93, and each of the first down-sampling based model 91, the second down-sampling based model 92 and the third down-sampling based model 93 may have the same structure. For example, the first down-sampling based model 91 of a first stage may receive the input parameters D91 and the grid data D92 and may receive the grid data D93 down-sampled from the grid data D92. The grid data D92 received in the first stage may have a highest resolution and may correspond to the grid data D82 generated from the attribute profile data D81 by the interpolation of FIG. 8. The second down-sampling based model 92 of a second stage may receive the grid data D93 and a 3D feature map output from the first down-sampling based model 91 of the first stage and may receive the grid data D94 down-sampled from the grid data D93. The third down-sampling based model 93 of a final stage may receive the grid data D95 and a 3D feature map output from down-sampling based model of a previous stage.

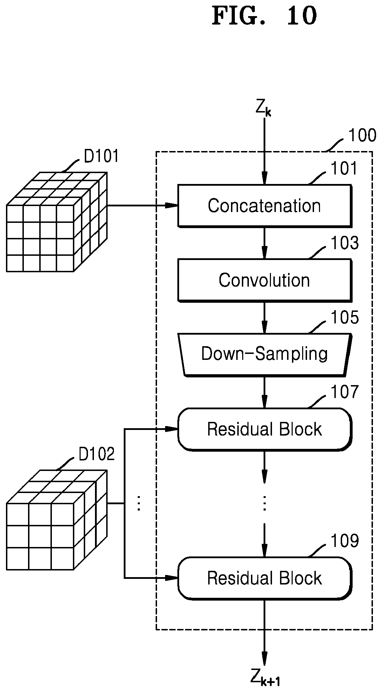

A down-sampling based model (for example, the first down-sampling based model 91) in each stage may output a 3D feature map having a higher resolution than that of input data (for example, D91) based on grid data D92 having a higher resolution and grid data D93 having a lower resolution. Therefore, a 3D feature map D96 representing a state of a 3D structure from the input parameters D91 may be generated by a series of down-sampling based models. As described below with reference to FIG. 10, a down-sampling based model may include at least one residual block RB. Therefore, the at least one residual block RB included in the down-sampling based model may be referred to as a down-sampling based residual block RB.

FIG. 10 is a diagram illustrating a down-sampling based model 100 according to an embodiment. In detail, FIG. 10 illustrates a down-sampling based model 100 included in a kth stage of stages included in the at least one down-sampling based model 90 of FIG. 9 (where k is an integer more than 0). As described above with reference to FIG. 9, the down-sampling based model 100 may receive a 3D feature map $Z_k$ having a higher resolution, grid data D101 having a higher resolution, and grid data D102 having a lower resolution and may output a 3D feature map $Z_{k+1}$ having a lower resolution.

Hereinafter, the 3D feature map $Z_k$ having a higher resolution may be referred to as an input feature map $Z_k$, and the 3D feature map $Z_{k+1}$ having a lower resolution may be referred to as an output feature map $Z_{k+1}$. Also, the grid data D101 having a higher resolution may be referred to as first grid data D101, and the grid data D102 having a lower resolution may be referred to as second grid data D102. Referring to FIG. 10, the down-sampling based model 100 may include a concatenation 101, a convolution 103, down-sampling 105, and a series of residual blocks 107 and 109.

In the concatenation 101, values of the input feature map $Z_k$ may be concatenated with values of the first grid data D101. When the down-sampling based model 100 is included in the first stage, the input feature map $Z_k$ may be 1D input parameters D91, and values of the input parameters D91 may be respectively concatenated with values of the first grid data D101.

A result of the concatenation 101 may be provided to the convolution 103 (or a convolution layer), and a result of the convolution 103 may be provided to the down-sampling 105 (or a down-sampling layer). The down-sampling 105 may be performed based on an arbitrary scheme, and for example, may be based on max pooling, average pooling, and a (convolution) neural network. Therefore, a result of the down-sampling 105 may have a resolution which is lower than that of each of the input feature map $Z_k$ and the first grid data D101.

The result of the down-sampling 105 may be provided to the series of residual blocks 107 and 109. As illustrated in FIG. 10, each of the residual blocks 107 and 109 may receive the second grid data D102 as well as an output of a previous residual block. In some embodiments, each of the residual blocks 107 and 109 may have the same structure as that of the residual block 60 described above with reference to FIG. 6.

FIG. 11 is a diagram illustrating post-processing according to an embodiment. As described above with reference to FIG. 8, state data D112 may be generated from a 3D feature map D111 by post-processing 110. As illustrated in FIG. 11, the post-processing 110 may include flattening 111 and a network 112.

The 3D feature map D111 may include information about a state of a 3D structure and may be converted into 1D data through the flattening 111 so as to be provided to the network 112. The network 112 may include first to nth layers L1 to Ln (where n is an integer more than 1), and the first to nth layers L1 to Ln may process flattened data or an output of a previous layer. In some embodiments, each of the first to nth layers L1 to Ln may be a fully connected layer or a dense layer. The network 112 may be trained along with the at least one down-sampling based model 85 of FIG. 8. As described above with reference to FIG. 8, state data D112 may represent a state of a 3D structure (for example, a characteristic of a current) under a predetermined condition.

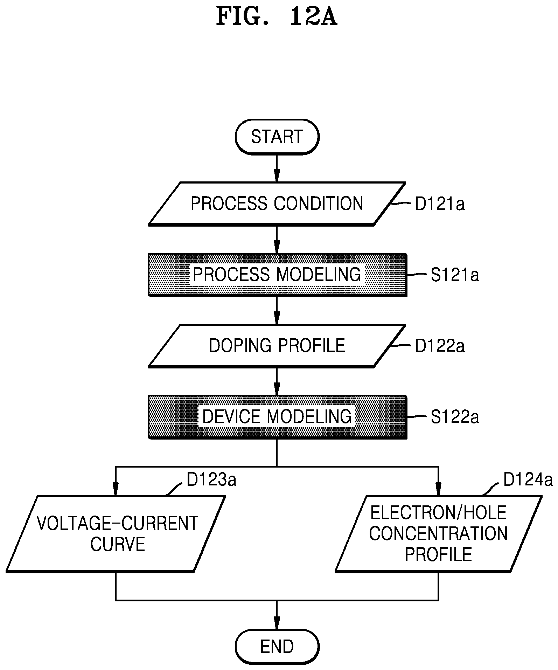

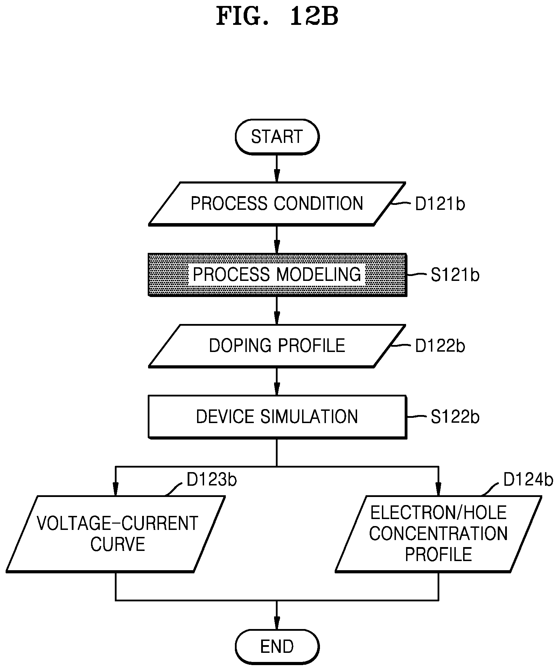

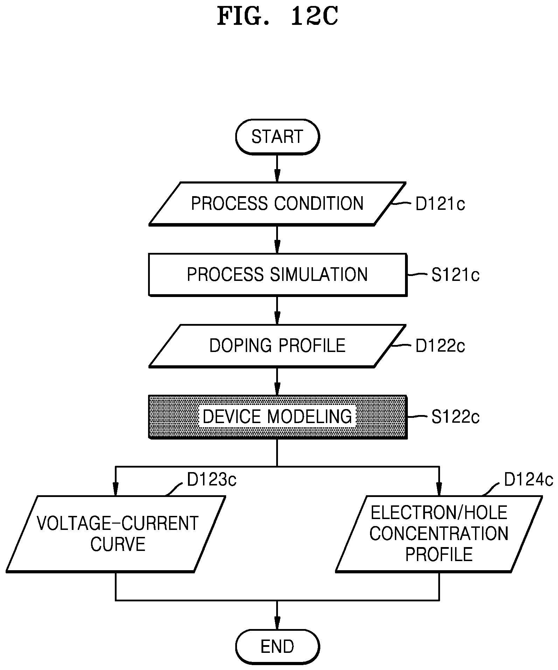

FIG. 12A, FIG. 12B and FIG. 12C are flowcharts illustrating examples of three-dimensional modeling according to embodiments. In detail, the flowcharts of FIG. 12A, FIG. 12B and FIG. 12C respectively illustrate examples of a method of modeling a semiconductor device as examples of 3D modeling.

In some embodiments, 3D modeling may replace a simulator for simulating a semiconductor device. For example, the 3D modeling 10 of FIG. 1 may replace a process simulator for simulating a doping profile of a semiconductor device from semiconductor process conditions, and the 3D modeling 80 of FIG. 8 may replace a device simulator for simulating a state of a semiconductor device from a doping profile and a condition assigned to the semiconductor device. In this case, the 3D modeling 10 of FIG. 1 may be referred to as process modeling, and the 3D modeling 80 of FIG. 8 may be referred to as device modeling.

Referring to FIG. 12A, both of a process simulator and a device simulator may be replaced with 3D modeling. For example, a process condition D121a may be provided to process modeling S121a, and the process modeling S121a may generate a doping profile D122a based on geometric data representing a semiconductor device. The doping profile D122a may be provided to device modeling S122a, and the device modeling S122a may generate a voltage-current curve D123a and an electron/hole concentration profile D 124a based on voltages assigned to a semiconductor device.

Referring to FIG. 12B, a process simulator may be replaced with 3D modeling. For example, a process condition D121b may be provided to process modeling S121b, and the process modeling 121b may generate a doping profile D122b based on geometric data representing a semiconductor device. The doping profile D122b may be provided to a device simulation S122b, and the device simulation S122b may generate a voltage-current curve D123b and an electron/hole concentration profile D124b based on voltages assigned to a semiconductor device.

Referring to FIG. 12C, a process simulator may be replaced with 3D modeling. For example, a process condition D121c may be provided to a process simulation S121c, and the process simulation S121c may generate a doping profile D122c based on geometric data representing a semiconductor device. The doping profile D122c may be provided to device modeling S122c, and the device modeling S122c may generate a voltage-current curve D123c and an electron/hole concentration profile D124c based on voltages assigned to a semiconductor device.

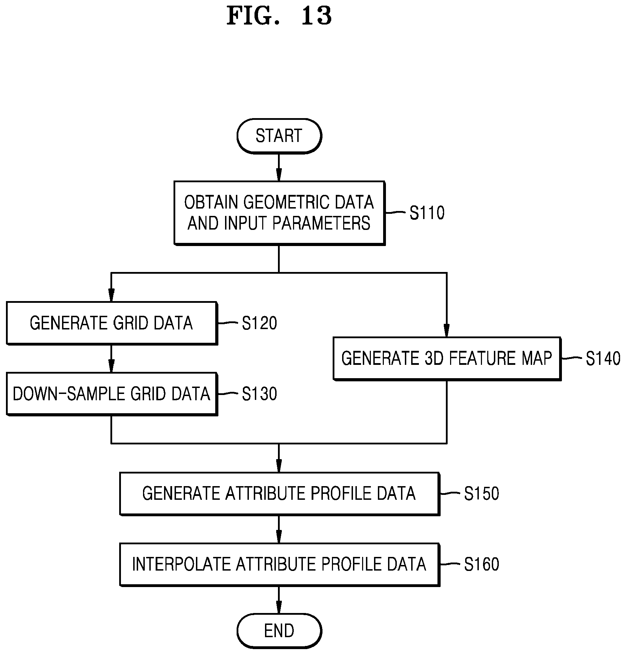

FIG. 13 is a flowchart illustrating a method for three-dimensional modeling according to an embodiment. In detail, the flowchart of FIG. 13 illustrates a method for 3D modeling of generating an attribute profile of a 3D structure. As illustrated in FIG. 13, the method of the 3D modeling may include operations S110 to S150. Hereinafter, FIG. 13 will be described with reference to FIG. 1.

Referring to FIG. 13, in operation S110, geometric data D11 and input parameters D15 may be obtained. The geometric data D11 may represent a 3D structure, and the input parameters D15 may include factors for determining an attribute of the 3D structure. In some embodiments, the geometric data D11 and the input parameters D15 may be generated by a simulator, or may be the same as an input of the simulator.

In operation S120, grid data D12 may be generated. In order to perform 3D modeling based on deep learning, the grid data D12 having a uniform grid may be generated from the geometric data D11. In some embodiments, the grid data D12 may have a grid corresponding to a minimum interval of a grid of the geometric data D11 and may be generated by interpolating the grid of the geometric data D11.

In operation S130, the grid data D12 may be down-sampled. A 3D feature map D16, as described below, generated from the input parameters D15 may have a low resolution. Therefore, the grid data D12 having a high resolution may be progressively down-sampled, whereby a plurality of pieces of down-sampled grid data may be generated.

In operation S140, the 3D feature map D16 may be generated. In order to be provided to a machine learning model along with 3D grid data, 1D input parameters D15 may be pre-processed, and thus, the 3D feature map D16 may be generated.

In operation S150, attribute profile data D17 may be generated. For example, the grid data D12 generated in operation S120, the down-sampled grid data generated in operation S130, and the 3D feature map D16 generated in operation S140 may be provided to at least one up-sampling based model 18. The at least one up-sampling based model 18 may be in a state where the at least one up-sampling based model 18 has been trained to output attribute profile data corresponding to a 3D feature map and grid data and may output attribute profile data D17 representing an attribute of a 3D structure.

In operation S160, the attribute profile data D17 may be interpolated. The attribute profile data D17 generated in operation S150 may have the same grid as that of the grid data D12 generated in operation S120. For an attribute profile compatible with a simulator, the attribute profile data D17 may be interpolated to have the same grid as that of the geometric data D11 based on the geometric data D11.

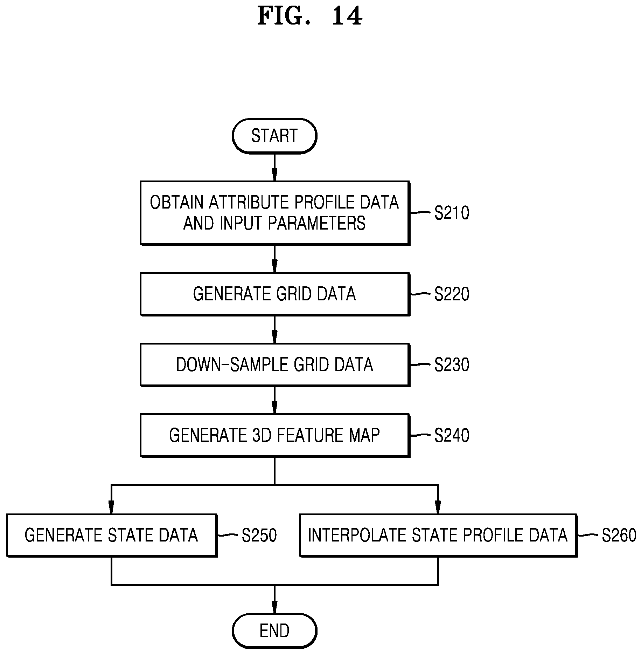

FIG. 14 is a flowchart illustrating a method for 3D modeling according to an embodiment. In detail, the flowchart of FIG. 14 illustrates a method for 3D modeling of generating a state of a 3D structure. As illustrated in FIG. 14, the method for 3D modeling may include operations S210 to S260. Hereinafter, FIG. 14 will be described with reference to FIG. 8.

Referring to FIG. 14, in operation S210, attribute profile data D81 and input parameters D85 may be obtained.

The attribute profile data D81 may represent an attribute of a 3D structure, and the input parameters D85 may represent an environment of the 3D structure. In some embodiments, the attribute profile data D81 may be generated by the 3D modeling method of FIG. 13 or a simulator.

In operation S220, grid data D82 may be generated. In order to perform 3D modeling based on deep learning, the grid data D82 having a uniform grid may be generated from the attribute profile data D81. In some embodiments, the grid data D82 may have a grid corresponding to a minimum interval of a grid of the attribute profile data D81 and may be generated by interpolating the grid of the attribute profile data D81.

In operation S230, the grid data D82 may be down-sampled. In order to generate a below-described 3D feature map D86 having a low resolution, the grid data D82 having a high resolution may be down-sampled, and thus, a plurality of pieces of down-sampled grid data may be generated.

In operation S240, the 3D feature map D86 may be generated. For example, the input parameters D85, the grid data D82 generated in operation S220, and the down-sampled grid data generated in operation S230 may be provided to at least one down-sampling based model 85. The at least one down-sampling based model 85 may be in a state where the at least one down-sampling based model 85 has been trained to output the 3D feature map D86 corresponding to the input parameters D85 and grid data and may output the 3D feature map D86 representing an attribute of a 3D structure.

In operation S250, state data D87 may be generated. For example, the 3D feature map D86 generated in operation S240 may be post-processed, and thus, state data D87 may be generated. In some embodiments, the 3D feature map D86 may be flattened as 1D data and flattened data may pass through a series of fully connected layers, and thus, the state data D87 may be generated.

In operation S260, state profile data D88 may be generated. The state profile data D88 may three-dimensionally represent a state of a 3D structure. Therefore, the 3D feature map D86 generated in operation S240 may be provided to the at least one down-sampling based model 85. The at least one down-sampling based model 85 may generate the state profile data D88 having a high resolution based on the 3D feature map D86 and grid data. In some embodiments, the state profile data D88 may be interpolated to have a non-uniform grid based on the attribute profile data D210 having a non-uniform grid, and thus, state profile data compatible with a simulator may be generated.

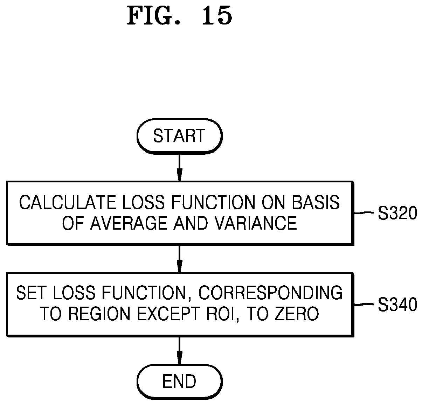

FIG. 15 is a flowchart illustrating a method for three-dimensional modeling according to an embodiment. In detail, the flowchart of FIG. 15 illustrates a method of training a machine learning model used in 3D modeling. In some embodiments, the method of FIG. 15 may be used to train an arbitrary machine learning model described above with reference to the drawings. As illustrated in FIG. 15, a method for 3D modeling may include operations S320 to S340.

Referring to FIG. 15, a loss function may be calculated based on an average and a variance in operation S15. In some embodiments, models used in 3D modeling may be trained to conform to a certain distribution. For example, an output of a simulator based on Monte Carlo (MC) may conform to a Gaussian distribution, and a loss function f(x) used in training of a model may be defined as expressed in the following [Equation 1]:

[Equation 1]

$$f(x) = \frac{(y - u(x))^2}{2\sigma^2(x)} + \frac{\log(\sigma^2(x))}{2}$$

In [Equation 1], x may denote an output of 3D modeling, u(x) may denote an average of outputs of the 3D modeling, $\sigma^2(x)$ may denote a variance of the outputs of the 3D modeling, and y may denote training data (for example, an output of a simulator). Therefore, an output of 3D modeling including machine learning models which are trained by using a loss function defined as in [Equation 1] may conform to the Gaussian distribution.

In operation S340, a loss function in association with data corresponding to a region except an ROI may be set to zero. For example, as described above with reference to FIG. 2A and FIG. 2B, there may be a portion (e.g., an ROI) where an attribute or a state is considered in a 3D structure, and a value of a loss function corresponding to a region except the ROI may be set to zero so that a region except the ROI does not affect training. For example, as described above with reference to FIG. 2A and FIG. 2B, in a case where a value corresponding to a region except an ROI is masked as zero, when y is zero in [Equation 1], the loss function f(x) may be set to zero regardless of x.

FIG. 16 is a block diagram illustrating a computer system 160 according to an embodiment. In some embodiments, the computer system 160 of FIG. 16 may perform training of machine learning models used in 3D modeling described above with reference to the drawings and may be referred to as a 3D modeling system or a training system.

The computer system 160 may denote an arbitrary system including a general-purpose or special-purpose computer system. For example, the computer system 160 may include a personal computer (PC), a server computer, a laptop computer, and an appliance product. As illustrated in FIG. 16, the computer system 160 may include at least one processor 161, a memory 162, a storage system 163, a network adapter 164, an I/O interface 165 (input/output interface), and a display 166.

The at least one processor 161 may execute a program module including an instruction executable by a computer system. The program module may include routines, programs, objects, components, a logic, and a data structure, which perform a certain operation or implement a certain abstract data format. The memory 162 may include a computer system-readable medium of a volatile memory type such as random access memory (RAM). The at least one processor 161 may access the memory 162 and may execute instructions loaded into the memory 162. The storage system 163 may non-volatilely store information, and in some embodiments, may include at least one program product including a program module which is configured to perform training of machine learning models for 3D modeling described above with reference to the drawings. In a non-limiting embodiment, a program may include an operating system (OS), at least one application, other program modules, and other program data.

The network adapter 164 may provide an access to a local area network (LAN), a wide area network (WAN), and/or a common network (for example, Internet). The I/O interface 165 may provide a communication channel corresponding to a peripheral device such as a keyboard, a pointing device, or an audio system. The display 166 may output various pieces of information so that a user check the information.

In some embodiments, training of machine learning models for 3D modeling described above with reference to the drawings may be implemented with a computer program product. The computer program product may include a non-transitory computer-readable medium (or a storage medium) including computer-readable program instructions for allowing the at least one processor 161 to perform image processing and/or training of models. In a non-limiting embodiment, a computer-readable instruction may include an assembler instruction, an instruction set architecture (ISA) instruction, a machine instruction, a machine dependent instruction, a micro-code, a firmware instruction, state setting data, or a source code or an object code written in at least one programming language. A computer-readable medium is defined to be any medium that constitutes patentable subject matter under 35 U.S.C. §101 and excludes any medium that does not constitute patentable subject matter under 35 U.S.C. § 101. Memories described herein are more generally tangible storage mediums for storing data and executable software instructions and are non-transitory during the time software instructions are stored therein. As used herein, the term "non-transitory" is to be interpreted not as an eternal characteristic of a state, but as a characteristic of a state that will last for a period. The term "non-transitory" specifically disavows fleeting characteristics such as characteristics of a carrier wave or signal or other forms that exist only transitorily in any place at any time.

The computer-readable medium may include an arbitrary type of medium for non-temporarily keeping and storing instructions executed by the at least one processor 161 or an arbitrary instruction-executable device. The computer-readable medium may include an electronic storage device, a magnetic storage device, an optical storage device, an electromagnetic storage device, a semiconductor storage device, or an arbitrary combination thereof, but is not limited thereto. For example, the computer-readable medium may include a portable computer disk, a hard disk, RAM, read-only memory (ROM), electrically erasable read only memory (EEPROM), flash memory, static RAM (SRAM), a compact disk (CD), a digital video disk (DVD), a memory stick, a floppy disk, a mechanically encoded device such as a punch card, or an arbitrary combination thereof.

FIG. 17 is a block diagram illustrating a system 170 according to an embodiment. In some embodiments, 3D modeling according to an embodiment may be executed by the system 170. Therefore, the system 170 may have low complexity and may quickly generate an accurate result.

Referring to FIG. 17, the system 170 may include at least one processor 171, a memory 173, an AI accelerator 175 (artificial intelligence accelerator), and a hardware accelerator 177, and the at least one processor 171, the memory 173, the AI accelerator 175, and the hardware accelerator 177 may communicate with one another through a bus 179. In some embodiments, the at least one processor 171, the memory 173, the AI accelerator 175, and the hardware accelerator 177 may be included in one semiconductor chip. Also, in some embodiments, at least two of the at least one processor 171, the memory 173, the AI accelerator 175, and the hardware accelerator 177 may be included in each of two or more semiconductor chips mounted on a board.

The at least one processor 171 may execute instructions. For example, the at least one processor 171 may execute instructions stored in the memory 173 to execute an OS and may execute applications executed in the OS. In some embodiments, the at least one processor 171 may execute instructions, and thus, the AI accelerator 175 and/or the hardware accelerator 177 may instruct an operation and may obtain a performance result of an operation from the AI accelerator 175 and/or the hardware accelerator 177. In some embodiments, the at least one processor 171 may include an application specific instruction set processor (ASIP) customized for a certain purpose and may support a dedicated instruction set.

The memory 173 may have an arbitrary structure which stores data. For example, the memory 173 may include a volatile memory device such as dynamic RAM (DRAM) or SRAM, and moreover, may include a non-volatile memory device such as flash memory or resistive RAM (RRAM). The at least one processor 171, the AI accelerator 175, and the hardware accelerator 177 may store data (for example, IN, IMG_I, IMG_O, and OUT of FIG. 2) in the memory 173 through the bus 179, or may read the data (for example, IN, IMG I, IMG_O, and OUT of FIG. 2) from the memory 173.

The AI accelerator 175 may denote hardware designed for AI applications. In some embodiments, the AI accelerator 175 may include a neural processing unit (NPU) for implementing a neuromorphic structure, and moreover, may process input data provided from the at least one processor 171 and/or the hardware accelerator 177 to generate output data and may provide the output data to the at least one processor 171 and/or the hardware accelerator 177. In some embodiments, the AI accelerator 175 may be programmable and may be programmed by the at least one processor 171 and/or the hardware accelerator 177.

The hardware accelerator 177 may be referred to as hardware designed for performing a certain operation at a high speed. For example, the hardware accelerator 177 may be designed to perform data conversion such as demodulation, modulation, encoding, or decoding at a high speed. The hardware accelerator 177 may be programmable and may be programmed by the at least one processor 171 and/or the AI accelerator 175.

In some embodiments, the AI accelerator 175 may execute machine learning models described above with reference to the drawings. For example, the AI accelerator 175 may execute each of the layers described above. The AI accelerator 175 may process an input parameter, a feature map, and/or the like to generate an output including useful information. Also, in some embodiments, at least some of models executed by the AI accelerator 175 may be executed by the at least one processor 171 and/or the hardware accelerator 177.

While the inventive concept(s) described herein have been particularly shown and described with reference to embodiments thereof, it will be understood that various changes in form and details may be made therein without departing from the spirit and scope of the following claims.

## Claims

1. A 3D modeling (three-dimensional modeling) method, the method comprising:

   obtaining geometric data representing a 3D structure and input parameters including factors determining an attribute of the 3D structure;
   generating, by a computer system comprising a memory that stores instructions and a processor that executes the instructions, grid data from the geometric data;
   sequentially generating at least one piece of down-sampled data from the grid data;
   generating a 3D feature map by pre-processing the input parameters; and
   generating attribute profile data, representing a profile of the attribute in the 3D structure, from the at least one piece of down-sampled data and the 3D feature map based on at least one machine learning model respectively corresponding to at least one stage.

2. The 3D modeling method of claim 1, wherein the generating the grid data comprises interpolating a grid of the geometric data to have a constant interval.

3. The 3D modeling method of claim 2, wherein the interval corresponds to a minimum interval in the grid of the geometric data.

4. The 3D modeling method of claim 1, wherein the generating the grid data comprises setting values, corresponding to a region except a region of interest of the 3D structure, to zero.

5. The 3D modeling method of claim 1, wherein the sequentially generating the at least one piece of down-sampled data comprises generating second grid data by down-sampling first grid data, and
   the generating the attribute profile data comprises:

   executing a first machine learning model based on output data of a previous stage, the first grid data, and the second grid data; and
   providing output data of the first machine learning model to a next stage.

6. The 3D modeling method of claim 5, wherein the executing the first machine learning model comprises:

   concatenating the output data of the previous stage and the second grid data;
   executing a convolution layer based on concatenated data;
   up-sampling output data of the convolution layer; and
   executing a series of residual blocks based on up-sampled data and the first grid data.

7. The 3D modeling method of claim 6, wherein the executing the series of residual blocks comprises executing a first residual block, and
the executing the first residual block comprises:

generating first data by concatenating the output data of the previous stage with the first grid data;
executing a first convolution layer based on the first data;
generating second data by concatenating output data of the first convolution layer with the first grid data;
executing a second convolution layer based on the second data;
generating third data by concatenating output data of the second convolution layer with the first grid data;
executing a third convolution layer based on the third data; and
adding the output data of the previous stage to output data of the third convolution layer.

8. The 3D modeling method of claim 1, further comprising training the at least one machine learning model based on a loss function,
wherein the loss function is based on an average and a variance of the attribute profile data.

9. The 3D modeling method of claim 8, wherein the training the at least one machine learning model comprises setting, to zero, the loss function in association with data corresponding to a region except a region of interest of the 3D structure.

10. The 3D modeling method of claim 1, wherein the 3D structure corresponds to a device of an integrated circuit,

the input parameters comprise process parameters used in manufacturing the integrated circuit, and
the attribute profile data represents a doping profile in the device.

11. The 3D modeling method of claim 1, further comprising generating profile data corresponding to a grid of the geometric data by interpolating a grid of the attribute profile data.

12. A system, comprising:

at least one processor; and
a non-transitory storage medium configured to store instructions, wherein, when executed by the processor, the instructions cause the at least one processor to:

obtain attribute profile data representing a profile of an attribute of a 3D structure and input parameters representing an environment of the 3D structure;
generate grid data from the attribute profile data;
sequentially generate at least one piece of down-sampled data from the grid data;
generate a 3D feature map from the grid data, the at least one piece of down-sampled data, and the input parameters based on at least one first machine learning model respectively corresponding to at least one first stage; and
generate state data representing a state of the 3D structure in the environment by post-processing the 3D feature map.

13. The system of claim 12, wherein the instructions cause the at least one processor to:

generate second grid data by the sequentially generating the at least one piece of down-sampled data by down-sampling first grid data; and
generate the attribute profile data by executing a first machine learning model based on output data of a previous first stage, the first grid data, and the second grid data and by providing output data of the first machine learning model to a next first stage.

14. The system of claim 13, wherein the instructions cause the at least one processor to execute the first machine learning model by:

concatenating the output data of the previous first stage with the first grid data;
executing a convolution layer based on concatenated data;
down-sampling output data of the convolution layer; and

executing a series of residual blocks based on down-sampled data and the second grid data.

15. The system of claim 12, wherein the 3D structure corresponds to a device of an integrated circuit,

the attribute profile data represents a doping profile in the device,
the input parameters represent voltages applied to the device, and
the state data represents a voltage and current characteristic of the device.

# FIG. 1

## FIG. 2A

FIG. 2B

L2

20b

SUB

S2

# FIG. 3

FIG. 4

EP 4 174 713 A1

# FIG. 5

# FIG. 6

$Y_j$

60

```
61  Concatenation

62  Convolution

    Normalization
    Activation

63  Concatenation

64  Convolution

    Normalization
    Activation

65  Concatenation

66  Convolution
```

D60

67 (+)

Normalization
Activation

$Y_{j+1}$

# FIG. 7

FIG. 8

EP 4 174 713 A1

# FIG. 9

EP 4 174 713 A1

# FIG. 10

**FIG. 11**

# FIG. 12A

```
              ( START )
                  │
                  ▼
   / PROCESS CONDITION /───D121a
                  │
                  ▼
   ▓ PROCESS MODELING ▓────S121a
                  │
                  ▼
   / DOPING PROFILE /──────D122a
                  │
                  ▼
   ▓ DEVICE MODELING ▓─────S122a
                  │
        ┌─────────┴─────────┐
        ▼                   ▼
  D123a                          D124a
 / VOLTAGE-CURRENT /    / ELECTRON/HOLE    /
 /     CURVE       /    / CONCENTRATION    /
                       /    PROFILE        /
        │                   │
        └─────────┬─────────┘
                  ▼
               ( END )
```

# FIG. 12B

```
                    ┌─────────┐
                    │  START  │
                    └────┬────┘
                         │
                         ▼
      ╱─────────────────────────────────╱
     ╱    PROCESS CONDITION            ╱───D121b
    ╱─────────────────────────────────╱
                         │
                         ▼
      ┌─────────────────────────────────┐
      │▓▓▓▓▓ PROCESS MODELING ▓▓▓▓▓▓▓▓▓▓│───S121b
      └─────────────────────────────────┘
                         │
                         ▼
      ╱─────────────────────────────────╱
     ╱     DOPING PROFILE              ╱───D122b
    ╱─────────────────────────────────╱
                         │
                         ▼
      ┌─────────────────────────────────┐
      │      DEVICE SIMULATION           │───S122b
      └─────────────────────────────────┘
              │                    │
    D123b     ▼                    ▼    D124b
   ╱─────────────────╱    ╱──────────────────────╱
  ╱  VOLTAGE-CURRENT ╱   ╱  ELECTRON/HOLE        ╱
 ╱     CURVE         ╱   ╱  CONCENTRATION        ╱
╱─────────────────╱     ╱  PROFILE              ╱
                       ╱──────────────────────╱
              │                    │
              └─────────┬──────────┘
                        ▼
                   ┌─────────┐
                   │   END   │
                   └─────────┘
```

# FIG. 12C

```
                    ┌──────────┐
                    │  START   │
                    └────┬─────┘
                         ▼
        ╱───────────────────────────╱
       ╱   PROCESS CONDITION       ╱──── D121c
      ╱───────────────────────────╱
                         ▼
        ┌───────────────────────────┐
        │    PROCESS SIMULATION      │──── S121c
        └───────────────────────────┘
                         ▼
        ╱───────────────────────────╱
       ╱     DOPING PROFILE         ╱──── D122c
      ╱───────────────────────────╱
                         ▼
        ┌───────────────────────────┐
        │░░░░░ DEVICE MODELING ░░░░░░│──── S122c
        └───────────────────────────┘
             │                   │
   D123c ────┘                   └──── D124c
      ▼                               ▼
 ╱──────────────╱           ╱──────────────────╱
╱ VOLTAGE-CURRENT╱         ╱  ELECTRON/HOLE     ╱
╱    CURVE       ╱         ╱  CONCENTRATION     ╱
╱──────────────╱          ╱   PROFILE          ╱
      │                          │
      └────────────┬─────────────┘
                   ▼
              ┌──────────┐
              │   END    │
              └──────────┘
```

# FIG. 13

START

OBTAIN GEOMETRIC DATA
AND INPUT PARAMETERS — S110

GENERATE GRID DATA — S120

GENERATE 3D FEATURE MAP — S140

DOWN-SAMPLE GRID DATA — S130

GENERATE ATTRIBUTE PROFILE DATA — S150

INTERPOLATE ATTRIBUTE PROFILE DATA — S160

END

# FIG. 14

START

OBTAIN ATTRIBUTE PROFILE DATA AND INPUT PARAMETERS — S210

GENERATE GRID DATA — S220

DOWN-SAMPLE GRID DATA — S230

GENERATE 3D FEATURE MAP — S240

GENERATE STATE DATA — S250    INTERPOLATE STATE PROFILE DATA — S260

END

# FIG. 15

```
        ┌─────────────┐
        │    START    │
        └─────────────┘
               │
               ▼
┌─────────────────────────────────┐
│ CALCULATE LOSS FUNCTION ON BASIS │──── S320
│      OF AVERAGE AND VARIANCE     │
└─────────────────────────────────┘
               │
               ▼
┌─────────────────────────────────┐
│ SET LOSS FUNCTION, CORRESPONDING │──── S340
│   TO REGION EXCEPT ROI, TO ZERO  │
└─────────────────────────────────┘
               │
               ▼
        ┌─────────────┐
        │     END     │
        └─────────────┘
```

# FIG. 16

Computer System — 160

- Processor(s) — 161
- Network Adapter — 164
- Memory — 162
- I/O Interface — 165
- Storage System — 163
- Display — 166

# FIG. 17

Europäisches
Patentamt

European
Patent Office

Office européen
des brevets

# EUROPEAN SEARCH REPORT

Application Number

EP 22 20 3552

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/063999 A1 (KIM JAEHO [KR] ET AL) 4 March 2021 (2021-03-04) * paragraph [0061] - paragraph [0067]; figure 4 * | 1-15 | INV. G06F30/27 G06F30/17 |
| X | EP 3 441 819 A1 (ASML NETHERLANDS BV [NL]) 13 February 2019 (2019-02-13) * paragraph [0100] - paragraph [0103]; figure 1 * | 1-15 | |
| X | CN 113 536 661 A (UNIV XIDIAN) 22 October 2021 (2021-10-22) * abstract * | 1-15 | |

TECHNICAL FIELDS
SEARCHED      (IPC)

G06F

The present search report has been drawn up for all claims

| Place of search | Date of completion of the search | Examiner |
|---|---|---|
| Berlin | 20 February 2023 | Kirsten, Karl |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 3552

This annex lists the patent family members relating to the patent documents cited in  the above-mentioned European search report.
The members are as contained in the European Patent Office EDP file on
The European Patent Office is in no way liable for these particulars which are merely given for the purpose of information.

20-02-2023

| Patent document cited in search report | | Publication date | Patent family member(s) | | Publication date |
|---|---|---|---|---|---|
| US 2021063999 | A1 | 04-03-2021 | CN | 112446167 A | 05-03-2021 |
| | | | US | 2021063999 A1 | 04-03-2021 |
| EP 3441819 | A1 | 13-02-2019 | NONE | | |
| CN 113536661 | A | 22-10-2021 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210149022